(19) Europäisches Patentamt
European Patent Office
Office européen des brevets

(11) EP 2 168 410 B1

(12) # EUROPÄISCHE PATENTSCHRIFT

(45) Veröffentlichungstag und Bekanntmachung des Hinweises auf die Patenterteilung:
**16.05.2018 Patentblatt 2018/20**

(21) Anmeldenummer: **08748711.2**

(22) Anmeldetag: **19.03.2008**

(51) Int Cl.:
***H05K 1/02*** *(2006.01)*

(86) Internationale Anmeldenummer:
**PCT/DE2008/000536**

(87) Internationale Veröffentlichungsnummer:
**WO 2008/113343 (25.09.2008 Gazette 2008/39)**

(54) **ELEKTRONISCHE BAUGRUPPE MIT EINER LEITERBAHNSICHERUNG**

ELECTRONIC MODULE COMPRISING A CONDUCTOR FUSE

MODULE ÉLECTRONIQUE COMPORTANT UN SYSTÈME DE PROTECTION DES PISTES CONDUCTRICES

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **19.03.2007 DE 102007014280**

(43) Veröffentlichungstag der Anmeldung:
**31.03.2010 Patentblatt 2010/13**

(73) Patentinhaber: **Conti Temic Microelectronic GmbH**
**90411 Nürnberg (DE)**

(72) Erfinder:
- **BECKER, Markus**
**86633 Neuburg/Bruck (DE)**
- **ALTENRENGER, Urban**
**85055 Ingolstadt (DE)**
- **WAGENSONNER, Heinz**
**84101 Niedersüssbach (DE)**

(56) Entgegenhaltungen:
**EP-A- 0 774 887**
**WO-A-01/59799**
**WO-A-2005/039256**
**DE-A1-102005 026 404**
**US-A1- 2005 140 490**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 168 410 B1

## Beschreibung

Die vorliegende Erfindung betrifft eine elektronische Baugruppe mit einer Leiterbahnsicherung gemäß dem Oberbegriff von Patentanspruch 1.

Elektronische Baugruppen können insbesondere für einen Einsatz in elektronischen Steuergeräten, beispielsweise in Fahrdynamikreglern oder Reglern für elektronische Bremssysteme, vorgesehen sein. Es finden dabei eine Vielzahl von Bauelementen Verwendung. Bei Auftreten von Defekten aufgrund von Fehlern dieser Bauelemente selbst oder einer eventuelle äußeren elektrischen, mechanischen oder Umweltbelastung kann ein solcher Defekt zu schwerwiegenden Folgefehlern, wie z.B. einer starken thermischen Belastung bis hin zum Versagen der gesamten Baugruppe oder der Beschädigung von benachbarten Bauteilen führen.

Eine Absicherung der Bauelemente, die insbesondere ohne weitere Strombegrenzung direkt an einer hochstromfähigen Batterie betrieben werden, wie z.B. in Kraftfahrzeugen, ist demnach erforderlich, um solche Fälle sicher zu vermeiden.

Aus der internationalen Patentanmeldung WO 2004/002202 A1 ist beispielsweise eine Leiterplatte bekannt, bei der die Spannungsversorgung mit einer oder mehreren Versorgungsleiterbahnen verbunden ist. Zur Absicherung gegen die übermäßige Entstehung von Wärme weist die Leiterplatte mindestens eine Unterbrechung der Versorgungsleiterbahnen auf, welche mit einer Schmelzbrücke leitend überbrückt ist. Die Schmelzbrücke enthält dabei ein Basismaterial, welches einen Schmelzpunkt aufweist, der niedriger ist als der Schmelzpunkt des Materials der Versorgungsleiterbahnen.

Weitere Schaltungen mit Leiterbahnsicherungen sind in den Dokumenten DE 10 2005 026404 A1 (2006-01-19), WO 2005/039256 A1 (2005-04-28) und WO 01/59799 A1 (2001-08-16) offenbart.

Die Aufgabe der vorliegenden Erfindung liegt darin, eine einfache und kostengünstige Maßnahme zur Absicherung gegen thermische Überbelastung einer elektronischen Baugruppe vorzusehen.
Diese Aufgabe wird erfindungsgemäß durch eine elektronische Baugruppe mit den Merkmalen von Patentanspruch 1 gelöst. Weiterbildungen und Einzelheiten der vorliegenden Erfindung sind Gegenstand der jeweiligen Unteransprüche.
In der nachfolgenden Beschreibung werden die Merkmale und Einzelheiten der vorliegenden Erfindung in Zusammenhang mit den beigefügten Zeichnungen anhand von Ausführungsbeispielen näher erläutert. Dabei sind in einzelnen Varianten beschriebene Merkmale und Zusammenhänge grundsätzlich auf alle Ausführungsbeispiele übertragbar. In den Zeichnungen zeigen:

Fig. 1 eine Draufsicht auf eine Leiterplatte einer erfindungsgemäßen elektronischen Baugruppe,

Fig. 2 ein Beispiel für die Funktionsweise der erfindungsgemäßen Leiterbahnsicherung,

Fig. 3 ein Schaubild zur gegenseitigen Beeinflussung von Temperatur und spezifischem Widerstand,

Fig. 4 ein Diagramm, in dem der spezifische Widerstand von Kupfer in Abhängigkeit von der Temperatur dargestellt ist,

Fig. 5 ein Schaubild zur Erläuterung der Berechnung der Abhebehöhe einer Leiterbahn,

Fig. 6 ein Infrarotbild mit der Temperaturverteilung an der Leiterbahnsicherung,

Fig. 7 eine Seitenansicht auf eine Weiterbildung der vorliegenden Erfindung,

Fig. 8 eine Draufsicht auf Fig. 7,

Fig. 9 ein Ausführungsbeispiel der vorliegenden Erfindung mit Lotpunkten,

Fig. 10 ein Ausführungsbeispiel der vorliegenden Erfindung ohne Lotpunkte und

Fig. 11 ein bevorzugtes Ausführungsbeispiel der vorliegen Erfindung.

In Fig. 1 ist eine Leiterplatte 1 mit einer Absicherung von Bauelementen oder Schaltungsteilen 2 von elektronischen Baugruppen über eine Leiterbahnsicherung 3 gezeigt. Die erfindungsgemäße Leiterbahnsicherung 3, auch Trace Fuse genannt, umfasst eine Engstelle 5, die gegenüber anderen Leiterbahnen 4 einen geringeren Leiterquerschnitt aufweist. Dabei ist Engstelle 5 so ausgeführt, dass sie in der Serienschaltung des jeweiligen Pfades den geringsten Leiterquerschnitt darstellt.

Ein Fehlstrom im Bauelement 2 führt zur Stromerhöhung in der Leiterbahn 4, besonders jedoch an der Engstelle 5 der Leiterbahn 4. Dadurch erhöht sich die Temperatur an dieser Engstelle 5. Dann schmilzt die Leiterbahnsicherung 3 und trennt dadurch den Stromfluss. Damit werden weitere Folgefehler wie z.B. eine zu starke thermische Belastung bis hin zum Versagen der gesamten Baugruppe oder der Beschädigung von benachbarten Bauteilen oder Baugruppen wirksam vermieden.

Wird diese Engstelle 5 in der Nähe des zu schützenden Bauelementes 2 platziert, so wirkt der Fehlstrom durch ein defektes Bauelement 2 und die damit verbundene Erwärmung zusätzlich zu einer früheren Auslösung der erfindungsgemäßen Leiterbahnsicherung 3.

Moderne Leiterplatten 1 sind nach dem Sandwichprinzip aufgebaut und umfassen üblicherweise mehrere Lagen. Die Engstelle 5 weist bevorzugt eine Breite von etwa 50 µm bis 200 µm und eine Länge von etwa 1,5 mm - 3 mm auf. Die Engstelle 5 wird in eine Strom führende Leiterbahn 4 auf der äußeren Lage der Leiterplatte 1 an einem oder mehreren zu schützenden Bauelement 2 eingefügt.

Die Werte von 50 µm bis 200 µm Leiterbahnbreite haben sich besonders bei einer Kupferschichtdicke von etwa 55 µm bewährt. Es muss eine Mindestlänge der Engstelle 5 von etwa 1,5 mm - 3 mm eingehalten werden, um den Einfluss größerer Kupferflächen in der Nähe gering zu halten. Dabei muss auf inneren Lagen der Leiterplatte 1 darauf geachtet werden, dass die Leiterbahnbreite entsprechend erhöht wird, um die voran stehende Forderung nach dem geringsten Querschnitt an der Engstelle mit genügend großer Sicherheit zu gewährleisten. Hierbei können beispielsweise bei 35µm Kupferschichtdicke auf der Innenlage etwa 0,75 mm Breite angesetzt werden. Bei anderen Kupferschichtdicken müssen die Werte entsprechend angepasst werden.

Es ist besonders sinnvoll, das Kupfer der Innenlage dicker und/oder breiter als die Leiterbahnen 4 auf den Außenlagen auszuführen, um die Leiterbahnsicherung oder Trace Fuse 3 bzw. deren Engstelle 5 zum schwächsten Glied in Kette zu machen, das am frühesten bei übermäßiger Stromlast überhitzt und durchschmilzt.

Der Auslösevorgang einer erfindungsgemäßen Leiterbahnsicherung 3 ohne weitere Zusatzmaßnahmen läuft gemäß den in Fig. 2 dargestellten Schritten 1) bis 4) ab.

1) Der Stromfluss durch die Leiterbahnsicherung 3 liegt weit unterhalb vom Auslösestrom.

2) Der Stromfluss steigt und erwärmt die Leiterbahnsicherung 3 an der Engstelle 5. Die Erwärmung führt zur Ausdehnung des Kupfers der Leiterbahn 4 an der Engstelle 5, während die Enden 6 im Vergleich kühl sind. Die Leiterbahnsicherung 3 muss sich verformen, um die Längenausdehnung der Leiterbahn 4 zu kompensieren.

3) Der Stromfluss steigt weiter. Die folgende Längenausdehnung führt zum Ausweichen der insbesondere aus Kupfer bestehenden Leiterbahn 4 an der Engstelle 5 in Richtung des geringsten Widerstandes. Die Engstelle 5 hebt somit von der Leiterplatte ab. Dies mindert an dieser Stelle die Karbonisierung des umgebenden Leiterplattenmaterials. Durch Erwärmung der Leiterbahn 4 wird diese Karbonisierung üblicherweise hervorgerufen.

4) Durch das Abheben der Engstelle 5 geht die Kühlung zum Substrat bzw. zur Leiterplatte verloren. Das Kupfer an der Engstelle 5 erwärmt sich jetzt noch stärker lokal. Unterstützt wird dies durch den positiven thermischen Widerstandskoeffizienten von Kupfer. Es bildet sich ein Hotspot 7 der die Leiterbahnsicherung 3 durchschmelzen lässt.

Beide Effekte, das Abheben und der positive spezifische Widerstand der insbesondere aus Kupfer bestehenden Leiterbahn 4, unterstützen sich dabei gegenseitig.

Als Abschätzung zum steigenden spezifischer Widerstand kann angenommen werden, dass der elektrische Widerstand von Kupfer von 0,018 Ω * $mm^2$/m bei einer Temperatur T von 20 °C auf 0,092 Q * $mm^2$/m bei 1080 °C wächst, d.h. die umgesetzte Leistung verfünffacht sich, der Hot Spot 7 wächst, was wiederum einen Anstieg der Temperatur zur Folge hat. Dieser Zusammenhang ist schematisch in Fig. 3 dargestellt.

Fig. 4 zeigt ein Diagramm, in dem der spezifische Widerstand von Kupfer in Abhängigkeit von der Temperatur gemäß der Formel

$$X(T) = X(T_0) * (1 + \alpha * (T - T_0))$$

dargestellt ist. Der Koeffizient α für den spezifischen Widerstand ist konstant (α = 0.0039 1/K).

Eine beispielsweise bei einer Temperatur T von 20 °C L1 = 2 mm lange Engstelle wird in fünf symmetrische Stücke je 0,4 mm mit innerhalb der jeweiligen Stücke konstanter Temperatur von 300 °C, 500 °C und 800 °C eingeteilt. Es wird angenommen, dass die Engstelle in annähernd dreieckiger Form abhebt. Bei einem linearen Ausdehnungskoeffizienten CTE von Kupfer von 16,4 * $10^{-6}$ 1/K kann die Ausdehnung $\Delta L2$ jeweils nach folgender Formel berechnet werden.

$$\Delta L2 = L1 * CTE * dT$$

Tabelle 1

L1

| | | | | | |
|---|---|---|---|---|---|
| | 0, 4 mm | 0, 4 mm | 0,4 mm | 0,4 mm | 0,4 mm |
| | 300 °C | 500 °C | 800 °C | 500 °C | 300 °C |
| $\Delta L2$: | 0,0018 | 0,0031 | 0,0051 | 0,0031 | 0,0018 |

Gemäß Tabelle 1 berechnet sich die absolute gesamte Ausdehnung $\Delta L2$ zu 0,015 mm

Fig. 5 zeigt ein Schaubild zur Erläuterung der vereinfachten Berechnung bzw. Handberechnung der Abhebehöhe einer Engstelle in Dreieckform.

Bei L1 = 2 mm, mit Hilfe der Formel

$$H^2 = (L/2)^2 - (L1 /2)^2$$

und einer Gesamtlänge $L = \Delta L2 + L1 = 2{,}015$ mm ergibt sich eine Abhebehöhe H = 0,12 mm.

Besonders bei sehr langsamem Stromanstieg kann die Engstelle der Leiterbahnsicherung lange genug heiß werden, um das Leiterplattenmaterial um die Engstelle herum zu karbonisieren. Mit geringer Wahrscheinlichkeit kann so ein leitfähiger Kanal parallel zur Leiterbahnsicherung entstehen, der selbst nach dem Durchbrechen der Leiterbahnsicherung den Stromfluss weiter trägt, wodurch die erfindungsgemäße Leiterbahnsicherung in ihrer Wirkung zumindest beeinträchtigt ist.

Im Folgenden werden einige vorteilhafte Weiterbildungen der vorliegenden Erfindung zur Beseitigung dieses Effektes beschrieben. Die aufgeführten Maßnahmen können erfindungsgemäß einzeln oder in Kombination verwendet werden.

Durch Weglassen von Lötstopplack auf und um die erfindungsgemäße Leiterbahnsicherung herum wird die Menge an karbonisierbarem organischem Material benachbart zur Leiterbahnsicherung verringert und das Abheben durch die Längenausdehnung des Kupfers erleichtert.

Durch Anbringen von Kühlflächen an den Rändern der Leiterbahnsicherung bzw. Anbinden der Leiterbahnsicherung an große Kupferflächen werden der Hotspot weiter in der Mitte eingegrenzt und die Ränder kühl gehalten, so dass sich kein durchgehend karbonisierter Kanal ergibt

In Fig. 6 ist eine Infrarotaufnahme von kühlen Rändern durch eine derartige Anbindung an große Kupferflächen bzw. eine Wärmesenke gezeigt. An der Engstelle 5 und insbesondere am Hotspot 7 herrscht eine Temperatur T von bis zu 600 °C.

Versehen der Kühlflächen 9 an den Rändern 8 der Leiterbahnsicherung 3 mit Lot 10. Wenn die geometrischen Verhältnisse Länge/Dicke der Engstelle 5 mit der Größe der Kühlfläche richtig gewählt sind, dann führt dies zu einem Aufschmelzen des Lotes 10. Daraus ergeben sich zwei wichtige Effekte, die im Folgenden in Zusammenhang mit Fig. 7 und 8 näher erläutert werden.

Zum Einen kühlt die Schmelzenthalpie des Lotes 10 die Ränder 8 der Engstelle 5. Das vermindert die Karbonisierung am Rand 8 der Engstelle 5 und erschwert somit das Ausbilden eines durchgängig karbonisierten Parallelschlusses.

Zum Andere löst sich das Kupfer der Engstelle 5 in dem Überangebot an flüssigem Lot 10. Dies führt zu einem frühzeitigen Auslösen der Leiterbahnsicherung 3 am Rande des Lots 10 und nicht mehr in der Mitte der Engstelle 5. Sowohl die Auslösetemperatur als auch der Auslösestrom sind deutlich geringer als bei einer Sicherung gleicher Geometrie aber ohne Lot. Auch dieser Effekt verhindert effektiv die Karbonisierung.

Die folgenden Abläufe sind in Fig. 7 und Fig. 8 dargestellt.

1) Lot 10 wurde auf insbesondere metallisierte Kühlflächen bzw. Wärmesenkenflächen 9 an einer oder beiden Rändern 8 der Engstelle 5 aufgebracht und im Lötprozess mit aufgeschmolzen. Das Aufbringen des Lots 10, insbesondere von Lötpaste, erfolgt vorzugsweise im gleichen Prozessschritt wie der Pastendruck der Leiterplatte.

2) Fließt ein hoher Strom durch die Engstelle 5, so heizt sich diese auf. Das Lot 10 an den Rändern 8 verflüssigt sich und das Kupfer der Engstelle 5 beginnt sich in dem Überangebot an Lot 10 zu lösen. Dadurch schnürt sich die Engstelle 5 elektrisch weiter ein, da das Kupfer-Lot-Gemisch an der Engstelle 5 erheblich schlechter leitet als das zuvor vorhandene reine Kupfer. Um ca. einen Faktor zehn, wie aus Tabelle 2 hervorgeht.

Tabelle 2

| Metall | Spezifischer Widerstand in $\Omega$*mm$^2$/m |
|---|---|
| Kupfer | 0,018 |
| Zinn | 0,115 |
| Blei | 0,208 |

3) Die Verschlechterung der Leitfähigkeit am Rand des Lots 10 führt zu einem erwünschten frühem Auslösen der Leiterbahnsicherung, ohne dass das Leiterplattenmaterial karbonisiert wird.

Fig. 9 zeigt ein Beispiel einer ausgelösten Leiterbahnsicherung 3 mit Lot 10 an den Rändern 8. Die erfindungsgemäße Leiterbahnsicherung 3 hat am Rand 8 an der Stelle 11 ausgelöst.

Fig. 10 zeigt ein Beispiel einer erfindungsgemäßen Leiterbahnsicherung 3 ohne Lot. Die Leiterbahnsicherung 3 löst in der Mitte der Engstelle 5 am Hotspot 7 aus.

In Fig. 11 ist eine weitere Variante der elektronischen Baugruppe mit Leiterbahnsicherung 3 dargestellt. Die Engstelle 5 hat vorzugsweise eine Länge von 1,5 mm - 3 mm. Neben der Engstelle 5 ist außerhalb des Gebietes 12 Lötstopplack aufgebracht, jedoch nicht auf der Engstelle 5 und der Kühlfläche bzw. Wärmesenke 9. An der Kühlfläche 9 ist Lot 10 aufgebracht. Die Leiterbahnen 4 sind mit größerem Querschnitt als die Engstelle 5 ausgebildet und führen zu nicht gezeigten Bauteilen.

## Patentansprüche

1. Elektronische Baugruppe mit einer Leiterplatte (1), die Bauelemente (2), Leiterbahnen (4) und eine Leiterbahnsicherung (3) aufweist, wobei die Leiterbahnsicherung (3) eine Engstelle (5) mit gegenüber den Leiterbahnen (4) geringerem Querschnitt umfasst und an zumindest einem Rand (8) der Leiterbahnsicherung (3) eine Kühlfläche bzw. Wärmesenke (9) vorgesehen ist, **dadurch gekennzeichnet, dass** an mindestens einer Kühlfläche bzw. Wärmesenke (9) Lot (10) aufgebracht ist.

2. Elektronische Baugruppe nach Anspruch 1, **dadurch gekennzeichnet, dass** das Material der Engstelle (5) dem Material der Leiterbahnen (4) entspricht, wobei das Material vorzugsweise Kupfer ist.

3. Elektronische Baugruppe nach einem der Ansprüche 1 oder 2, **dadurch gekennzeichnet, dass** die Engstelle (5) eine Breite von etwa 50 $\mu$m bis 200 $\mu$m aufweist.

4. Elektronische Baugruppe nach einem der vorhergehenden Ansprüche, **dadurch gekennzeichnet, dass** die Engstelle (5) eine Länge von mindestens 1,5 mm - 3 mm aufweist.

5. Elektronische Baugruppe nach einem der vorhergehenden Ansprüche, **dadurch gekennzeichnet, dass** die Engstelle (5) derart ausgebildet ist, dass sie sich bei Erwärmung ausdehnt und von der Leiterplatte (1) abhebt.

6. Elektronische Baugruppe nach einem der vorhergehenden Ansprüche, **dadurch gekennzeichnet, dass** an der Engstelle (5) kein Lötstopplack vorgesehen ist.

## Claims

1. Electronic module comprising a printed circuit board (1), which has components (2), conductor tracks (4) and a conductor fuse (3), the conductor fuse (3) comprising a constriction (5) with a smaller cross section than the conductor tracks (4) and a cooling area or heat sink (9) being provided on at least one edge (8) of the conductor fuse (3), **characterized in that** solder (10) is applied on at least one cooling area or heat sink (9).

2. Electronic module according to Claim 1, **characterized in that** the material of the constriction (5) corresponds to the material of the conductor tracks (4), the material preferably being copper.

3. Electronic module according to either of Claims 1 and 2, **characterized in that** the constriction (5) has a width of approximately 50 μm to 200 μm.

4. Electronic module according to one of the preceding claims, **characterized in that** the constriction (5) has a length of at least 1.5 mm - 3 mm.

5. Electronic module according to one of the preceding claims, **characterized in that** the constriction (5) is formed in such a way that it expands and lifts off from the printed circuit board (1) when heated.

6. Electronic module according to one of the preceding claims, **characterized in that** no solder resist is provided at the constriction (5).

## Revendications

1. Module électronique comportant une carte de circuit imprimé (1) qui comprend des composants (2), des pistes conductrices (4) et un système de protection des pistes conductrices (3), dans lequel le système de protection des pistes conductrices (3) comprend un étranglement (5) ayant une section transversale inférieure à celle des pistes conductrices (4) et dans lequel une surface refroidissante ou un puits thermique (9) est prévu sur au moins un bord (8) du système de protection des pistes conductrices (3), **caractérisé en ce que** de la soudure (10) est déposée sur au moins une surface refroidissante ou un puits thermique (9).

2. Module électronique selon la revendication 1, **caractérisé en ce que** le matériau de l'étranglement (5) correspond au matériau des pistes conductrices (4), dans lequel le matériau est de préférence le cuivre.

3. Module électronique selon l'une des revendications 1 ou 2, **caractérisé en ce que** l'étranglement (5) présente une largeur d'environ 50 μm à 200 μm.

4. Module électronique selon l'une des revendications précédentes, **caractérisé en ce que** l'étranglement (5) présente une longueur d'au moins 1,5 mm - 3 mm.

5. Module électronique selon l'une des revendications précédentes, **caractérisé en ce que** l'étranglement (5) est réalisé de manière à ce que, lors d'un échauffement, il se dilate et se décolle de la carte de circuit imprimé (1).

6. Module électronique selon l'une des revendications précédentes, **caractérisé en ce qu'**aucune réserve de soudure n'est prévue sur l'étrangement (5).

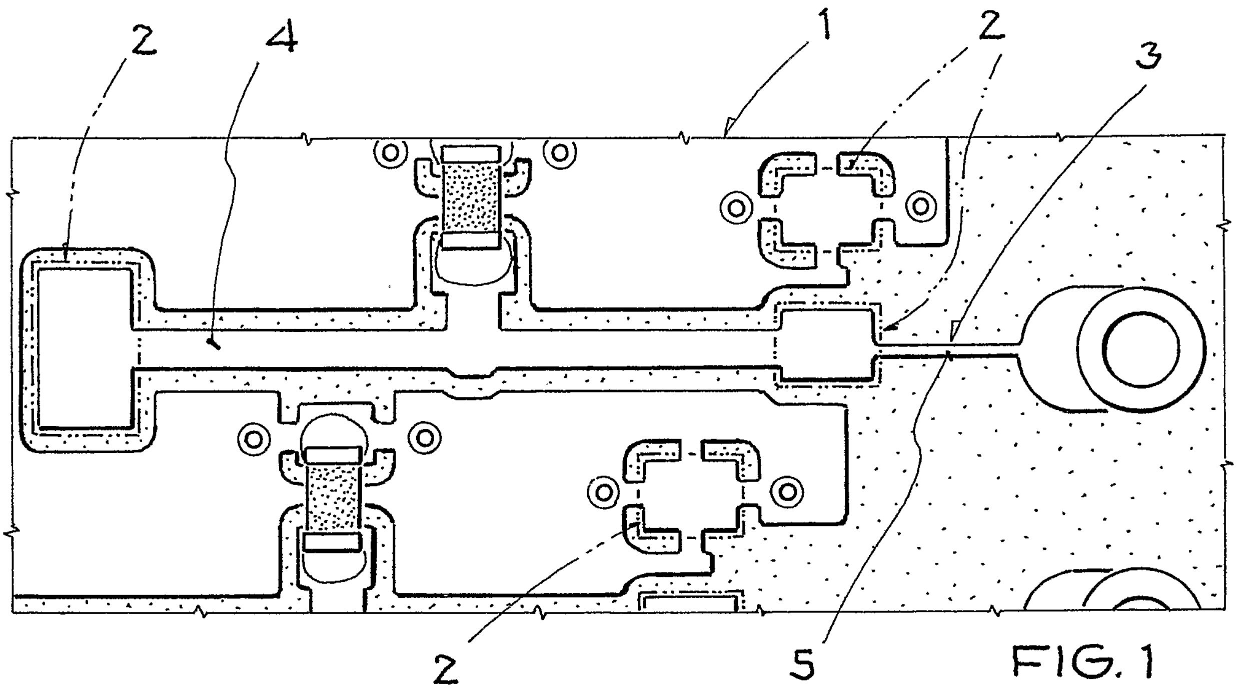


FIG. 1

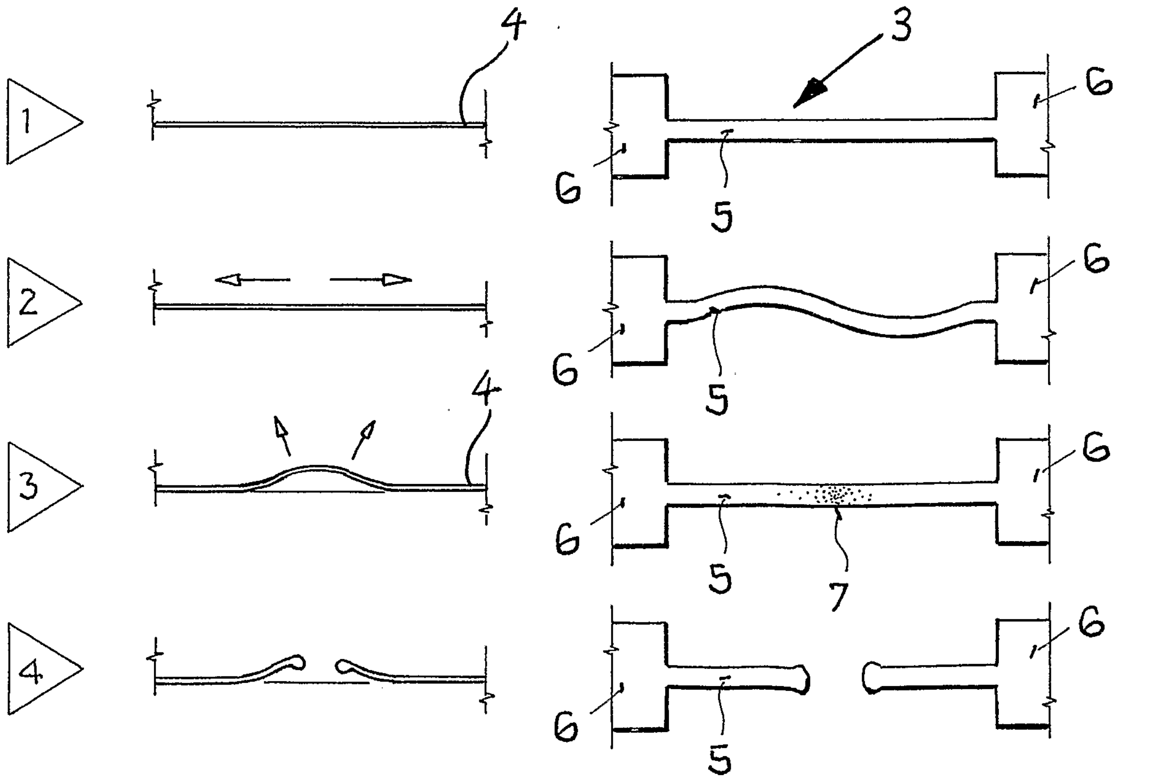


FIG. 2

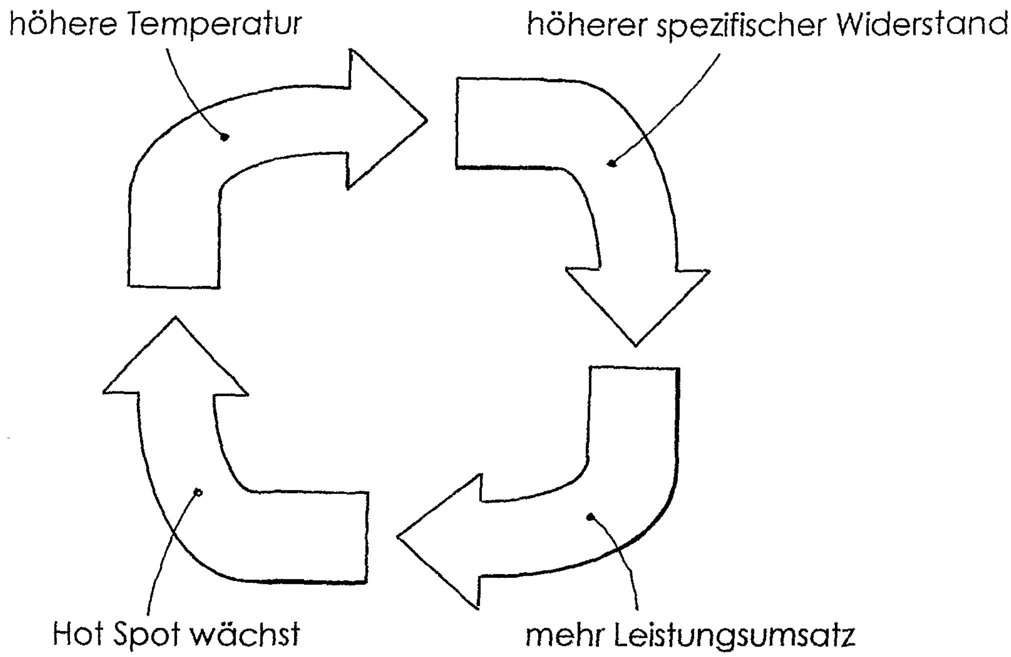
höhere Temperatur
höherer spezifischer Widerstand
Hot Spot wächst
mehr Leistungsumsatz

FIG. 3

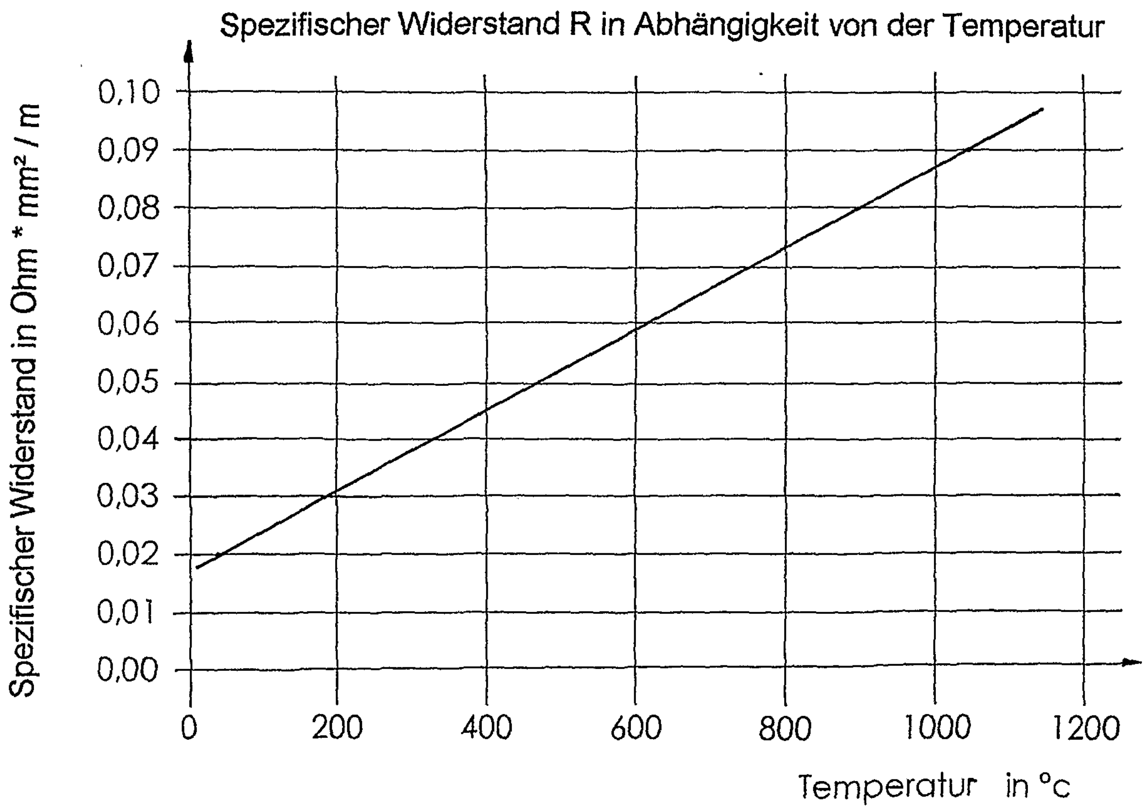
Spezifischer Widerstand R in Abhängigkeit von der Temperatur
Spezifischer Widerstand in Ohm * mm² / m
0,10
0,09
0,08
0,07
0,06
0,05
0,04
0,03
0,02
0,01
0,00
0
200
400
600
800
1000
1200
Temperatur in °c

FIG. 4

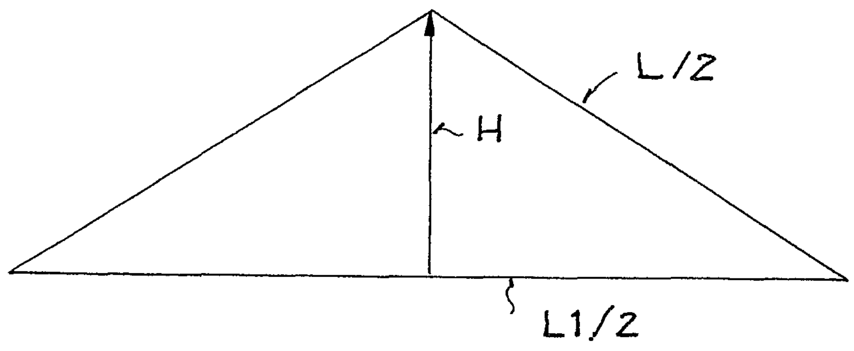


FIG. 5

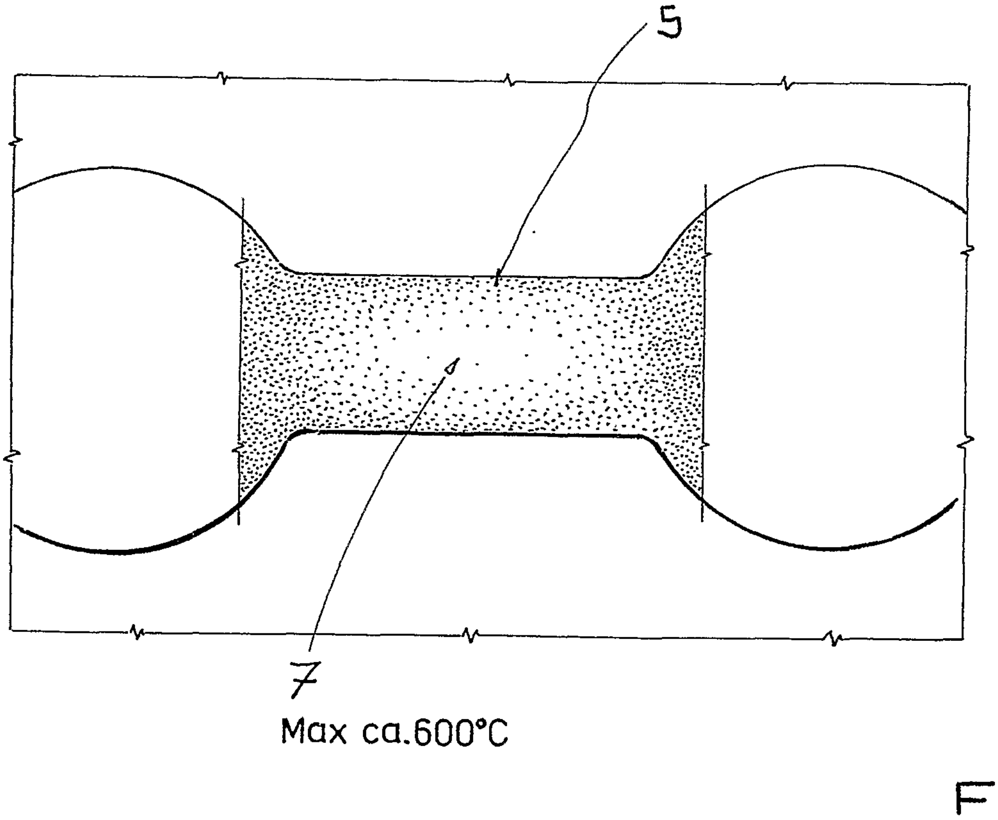


FIG. 6

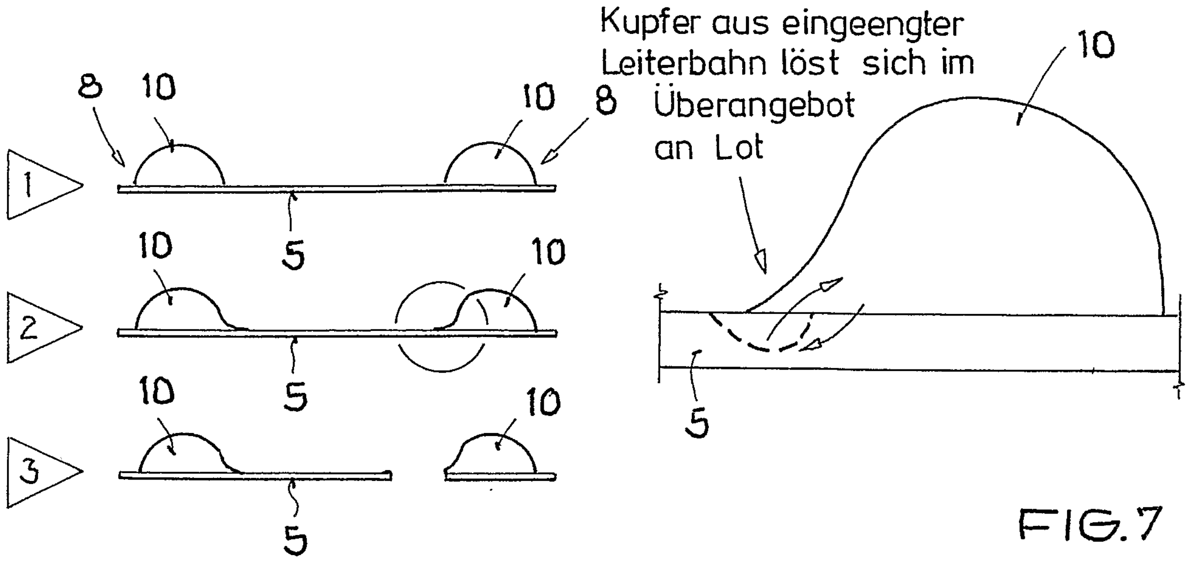
Kupfer aus eingeengter
Leiterbahn löst sich im
Überangebot
an Lot
1
2
3
5
8
10

FIG.7

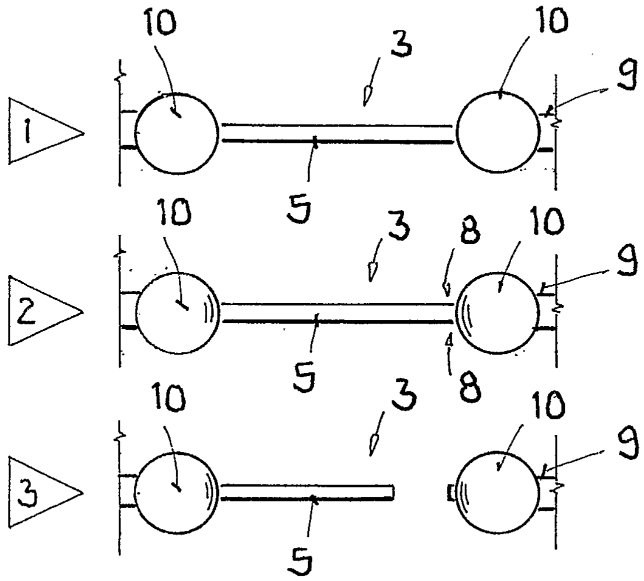
1
2
3
5
8
9
10

FIG.8

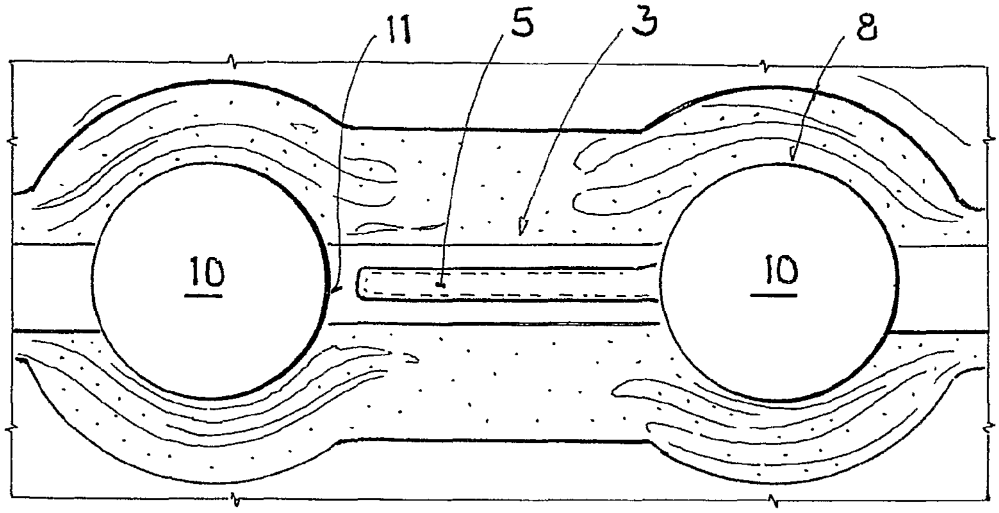


FIG. 9

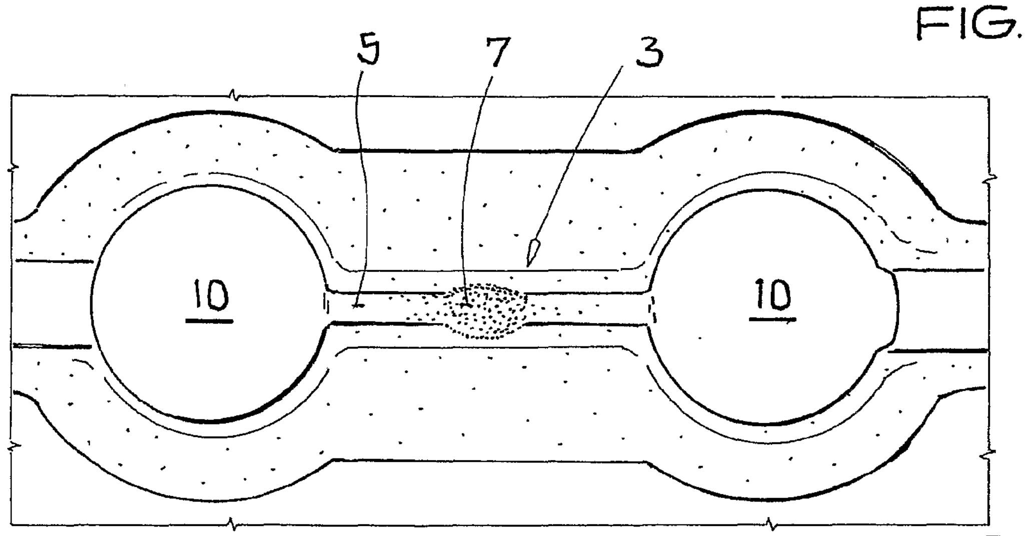


FIG. 10

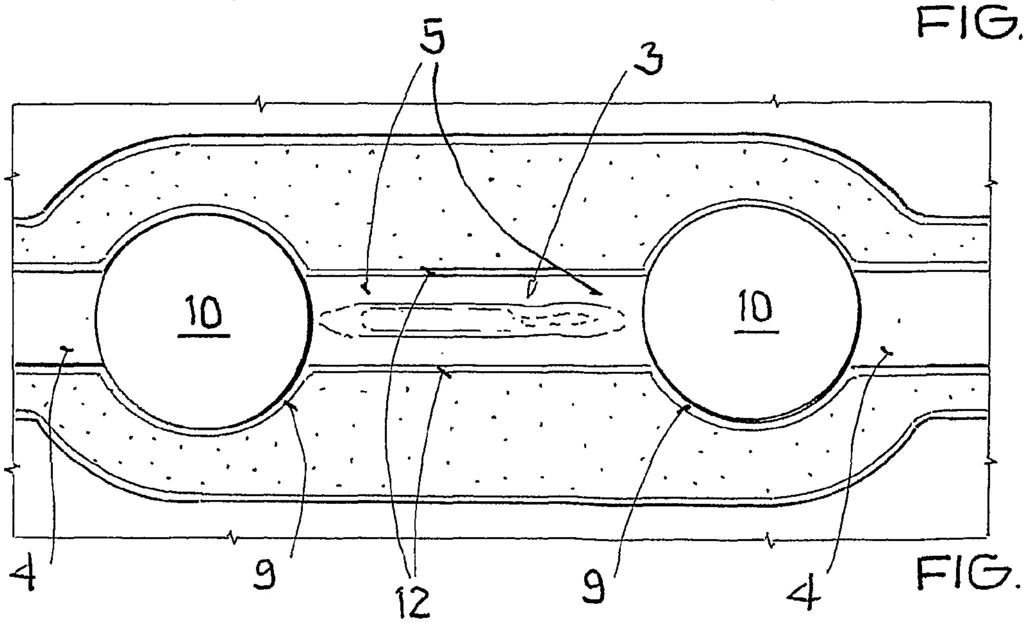


FIG. 11

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2004002202 A1
- DE 102005026404 A1
- WO 2005039256 A1
- WO 0159799 A1